# EUROPÄISCHE PATENTSCHRIFT

(11) **EP 1 369 380 B1**
(45) Veröffentlichungstag und Bekanntmachung des Hinweises auf die Patenterteilung: **23.08.2006**
(21) Anmeldenummer: 03019362.7
(22) Anmeldetag: 30.11.2001
(51) Int. Cl.: B81B 1/00, B81C 1/00, B01L 3/00, G01N 27/447, B01J 19/00

(54) **Mikrofluidisches Bauelement und Analysevorrichtung**
Microfluidic component and analysis device
Composant microfluidique et dispositif d'analyse

(30) Priorität: 05.12.2000 DE 10060433
(43) Veröffentlichungstag der Anmeldung: 10.12.2003
(62) Teilanmeldung aus: 01989549.9
(73) Patentinhaber: febit biotech GmbH, 69120 Heidelberg (DE)
(72) Erfinder: Strobelt, Tilo, 73098 Rechberghausen (DE); Frech, Johannes, c/o Innevo Consulting, 00920 Helsinki (FI); Nommensen, Peter, 78054 Villingen-Schwenningen (DE); Müller, Martin, 79331 Teningen (DE); Stähler, Cord-F., 69469 Weinheim (DE)
(74) Vertreter: Schoppe, Fritz

(56) Entgegenhaltungen:
- WO-A-00/11477
- WO-A-96/41864
- US-A- 5 498 392
- US-A- 5 744 366

## Beschreibung

Die vorliegende Erfindung bezieht sich auf die Analytik und insbesondere auf Fluidbauelemente, welche für analytische Anwendungen geeignet sind.

In der Analytik besteht ein großer Bedarf nach Fluidbauelementen und insbesondere nach Kapillarstrecken, um beispielsweise Flüssigkeiten durch Kapillarkräfte zu transportieren, um sie während des Transports untersuchen zu können, oder aber um Probebehälter zu erzeugen, in denen die Flüssigkeiten stehen, und deren Oberflächen mit chemischen Stoffen behandelt sind, damit bestimmte Probenfluide eine Reaktion mit diesen Stoffen eingehen, durch die sie beispielsweise eine Farbänderung erfahren. Um eine solche Farbänderung eines Probenfluids feststellen zu können, oder um allgemein die optischen Eigenschaften eines Probenfluids feststellen zu können, ist es wichtig, daß Fluidbauelemente auf beiden Seiten transparent sind, damit Analysen im Durchlicht beispielsweise unter Verwendung von Fluoreszenzeigenschaften durchgeführt werden können.

Kapillarstrecken werden heute in verschiedensten Bereichen der Technik, beispielsweise in der chemischen Analytik und Biochemie eingesetzt. Solche Kapillaren werden in Siliziumwafer geätzt und dann gedeckelt und damit verschlossen. So kann zum Verschließen solcher in Silizium geätzten Wafer zwar ein Glasdeckel verwendet werden. Rückseitig, also auf der anderen Seite der Kapillarstrecke, befindet sich jedoch der Substratwafer, welcher im allgemeinen nicht optisch transparent ist. Für Durchlichtanalysen sind solche Kapillarstrecken daher nicht geeignet. Um überhaupt optische Analysen mit solchen Kapillarstrecken durchführen zu können, muß auf die in das Silizium geätzten Fluidstrukturen z. B. eine Metallschicht aufgebracht werden, damit eine Reflexionsanalyse durchgeführt werden kann. Neben der Tatsache, daß solche Kapillarstrecken nicht für Durchlichtbestimmungen geeignet sind, ist das Aufbringen einer Spiegelschicht auf das Silizium ein weiterer Herstellungsschritt, welcher aufwendig ist und das Fluidbauelement verteuert.

Des weiteren ist es schwierig, mittels Ätzverfahren genaue Tiefen der Fluidstruktur einzustellen. So kann zwar mit der Trockenätztechnik ein sehr genau kontrollierbarer Materialabtrag erreicht werden. Nachteilig ist jedoch, daß die Ätzparameter sehr genau gesteuert werden müssen, was wiederum zu hohen Kosten solcher Kapillarbauelemente in der Herstellung führt. Werden die Ätzparameter nicht derart streng kontrolliert, so ergibt sich ein hoher Ausschuß in der Produktion.

Insbesondere auf dem Gebiet der Analytik setzen sich immer mehr Einweganalyseelemente durch. Fluidbauelemente entwickeln sich daher immer mehr zu Massenartikeln. Besonders an Massenartikel besteht die Anforderung, daß sie preisgünstig sind. Selbst kleine Preisunterschiede führen auf dem Markt daher bereits dazu, daß sich ein Produkt gegenüber einem anderen Produkt durchsetzt. Lediglich preiswerte Fluidbauelemente sind daher konkurrenzfähig.

Das U.S.-Patent Nr. 5,744,366 offenbart Vorrichtungen und Verfahren zum Durchführen einer schnellen und genauen Analyse einer Probe mit Zellen, die durch ihre Motilität gekennzeichnet sind. Verschiedene Tore, Kanäle und Kammern sowie andere Funktionselemente von für die Analyse eingesetzten Vorrichtungen werden aus einem Siliziumsubstrat durch Mikroabtragungstechniken wie beispielsweise Filmaufbringungstechniken, Laser-basierte Herstellungs- oder photolithographische Techniken, Kunststoff-Formungstechniken oder Ätzverfahren hergestellt. Hierzu wird ein Substrat, das einen Flusskanal umfasst, mit einer dünnen Gasabdeckung abgedeckt und versiegelt, beispielsweise durch anodisches Bonden. Andere durchsichtige oder undurchsichtige Abdeckungsmaterialien können verwendet werden, beispielsweise verschiedene organische Polymere. Alternativ können zwei Substrate sandwich-mäßig angeordnet werden. Wieder alternativ, kann ein Substrat zwischen zwei transparente Abdeckungen sandwich-mäßig angeordnet werden.

Die Aufgabe der vorliegenden Erfindung besteht darin, ein preisgünstiges Fluidbauelement sowie eine preisgünstige Analysevorrichtung zu schaffen.

Diese Aufgabe wird durch ein Fluidbauelement nach Patentanspruch 1 sowie durch eine Analysevorrichtung nach Patentanspruch 2 gelöst.

Der vorliegenden Erfindung liegt die Erkenntnis zugrunde, daß zur Herstellung eines Fluidbauelements ein Basiswafer verwendet wird, welcher ein Trägersubstrat, eine Zwischenschicht auf dem Trägersubstrat und eine Strukturschicht auf dem Trägersubstrat aufweist, wobei die Dicke der Strukturschicht die aktive Höhe der Fluidstruktur des Fluidbauelements bestimmt. Solche Basiswafer, welche beispielsweise SOI-Wafer sein können (SOI = Silicon On Insulator), werden mit genau spezifizierten Dicken der Halbleiterschicht angeboten. Im Falle von SOI-Wafern ist die Zwischenschicht die Isolator/Oxid-Schicht, während die Strukturschicht die Halbleiterschicht ist.

Solche Basiswafer können industriell sehr genau hergestellt werden. Da solche Basiswafer in großen Stückzahlen industriell angeboten werden, sind ihre Preise vergleichsweise günstig, da sie nicht nur auf dem Gebiet der Analytik eingesetzt werden können, sondern im gesamten Bereich der Elektronik oder Mikrostrukturtechnik.

Erfindungsgemäß wird die Halbleiterschicht des Basiswafers, also im Falle eines SOI-Wafers die Siliziumschicht, strukturiert, um eine Fluidstruktur des Fluidbauelements herzustellen, wobei sich die Fluidstruktur durch die Halbleiterschicht hindurch erstreckt. Die Zwischenschicht ist so ausgeführt, daß sie durch die Strukturierung der Strukturschicht im wesentlichen nicht beeinträchtigt wird und - im Falle von Ätzen - als Ätzstopp wirkt.

Dann wird eine transparente Scheibe aufgebracht, so daß die Fluidstruktur abgedeckt ist. Hierauf wird der Basiswafer von der anderen Seite bearbeitet, und zwar so, daß das Trägersubstrat und die Isolatorschicht entfernt werden. Die Fluidstruktur wird somit wieder an ihrer Rückseite geöffnet. Anschließend wird eine zweite transparente Scheibe auf der freiliegenden Seite der Halbleiterschicht angebracht, so daß die Fluidstruktur abgedeckt ist.

Falls die Zwischenschicht transparent ist, wie es bei SiO₂ der Fall ist, kann dieselbe auch verbleiben, da sie die Durchlichtanalysen nicht wesentlich beeinträchtigt.

Ein Vorteil der vorliegenden Erfindung besteht darin, daß nunmehr ein beidseitig transparentes Fluidbauelement geschaffen ist, das sich ohne weiteres für Durchlichtanalysen eignet.

Ein weiterer Vorteil der vorliegenden Erfindung besteht darin, daß die aktive Höhe der Fluidstruktur nicht mehr durch sehr genau gesteuerte Ätzparameter eingestellt werden muß, sondern einfach durch die Dicke der Halbleiterschicht bestimmt ist. Die Genauigkeit der aktiven Höhe der Fluidstruktur ist somit bereits vor der eigentlichen Herstellung des Fluidbauelements festgelegt, nämlich durch die vom Hersteller des Basiswafers spezifizierte Dicke der Halbleiterschicht.

Ein weiterer Vorteil der vorliegenden Erfindung besteht darin, daß während des Strukturierens der Halbleiterschicht Ätzverfahren eingesetzt werden können, welche nicht genau gesteuert zu werden brauchen. Vielmehr wirkt die Isolatorschicht des Basiswafers automatisch als Ätzstopp, so daß unabhängig von den Ätzparametern immer eine sehr genaue aktive Höhe der Fluidstruktur erreicht wird. Die einzige Anforderung besteht dahingehend, daß die Halbleiterschicht vollständig durchgeätzt wird, um eine Fluidstruktur mit konstanter Höhe zu erreichen.

Ein weiterer Vorteil der vorliegenden Erfindung besteht darin, daß mittels des gleichen Herstellungsverfahrens Fluidbauelemente für viele verschiedenen Anwendungen, also mit vielen verschiedenen entsprechenden aktiven Höhen der Fluidstrukturen einfach dadurch erhalten werden können, daß andere Basiswafer mit anderen Dicken der Halbleiterschichten ausgewählt werden. Da somit das gleiche Herstellungsverfahren für eine Vielzahl verschiedener Fluidbauelemente eingesetzt werden kann, verringern sich die Herstellungskosten pro Fluidbauelement, da selbst Kleinserien von Fluidbauelementen verschiedener Spezifikationen hergestellt werden können, ohne daß nach jeder Kleinserie eine aufwendige Umstellung der Produktionsanlage erforderlich ist.

Dies alles wird dadurch erreicht, daß der entscheidende Parameter, nämlich die aktive Höhe der Fluidstruktur, nicht mehr durch den Herstellungsprozeß selber, sondern durch das Ausgangsmaterial, nämlich den Basiswafer, festgelegt wird.

Erfindungsgemäß können somit beidseitig mit transparenten Scheiben, beispielsweise Glasdeckeln, verschlossene Fluidbauelemente mit hoher Präzision hergestellt werden. Die Genauigkeit wird also nicht mehr durch das Herstellungsverfahren bestimmt, sondern durch die Verwendung von Basiswafern. Aufgrund der Tatsache, daß die Fluidstrukturen durch Standard-Halbleitertechnologie-Prozeßschritte erreicht werden können, können auch sehr komplizierte Fluidstrukturen mit beliebigen Geometrien auf einem Basiswafer hergestellt werden, so daß das erfindungsgemäße Verfahren nicht zur Herstellung von Kapillarstrecken eingesetzt werden kann, sondern auch zur Herstellung von Kavitäten, Verzweigungen, passiven Ventilen und dergleichen.

Bevorzugte Ausführungsbeispiele der vorliegenden Erfindung werden nachfolgend bezugnehmend auf die beiliegenden Zeichnungen erläutert. Es zeigen:
- Fig. 1: eine Schnittansicht eines Basiswafers nach dem Schritt des Strukturierens der Halbleiterschicht;
- Fig. 2: eine Schnittansicht durch einen Basiswafer, auf dem eine erste transparente Scheibe aufgebracht ist;
- Fig. 3: eine Schnittansicht des Basiswafers, nachdem das Trägersubstrat und die Isolatorschicht entfernt ist; und
- Fig. 4: eine Schnittansicht eines erfindungsgemäßen Fluidbauelements, nachdem eine zweite transparente Scheibe an der Rückseite des Fluidbauelements angebracht worden ist.

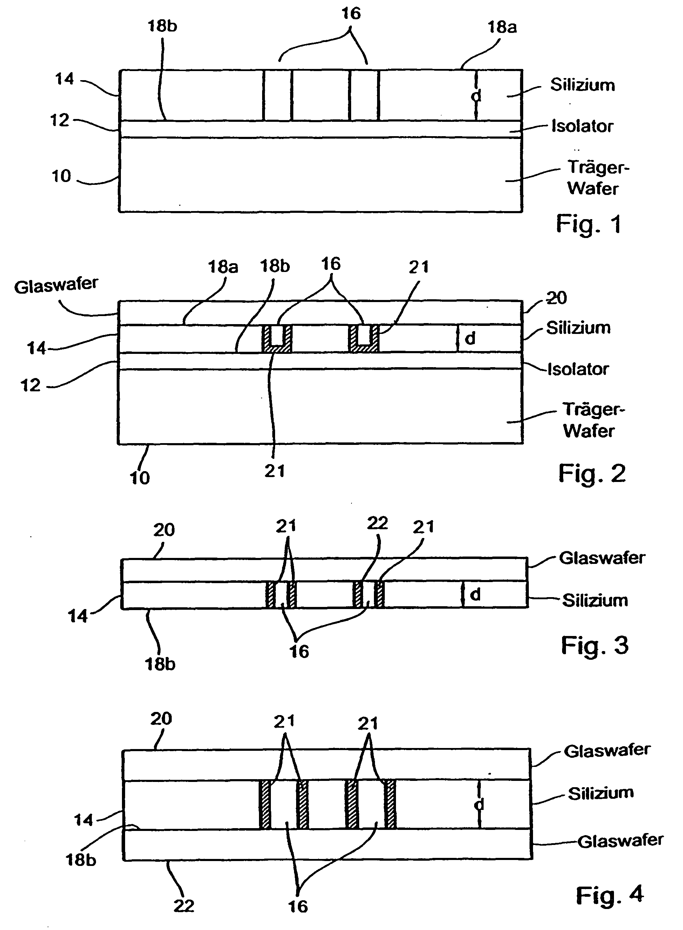

Fig. 1 zeigt einen Basiswafer mit einem Trägerwafer 10, auf dem eine Isolatorschicht 12 aufgebracht ist, welche wiederum von einer Halbleiterschicht 14 bedeckt ist. Vorzugsweise wird als Basiswafer eine SOI-Struktur verwendet, also eine Struktur, bei der die Halbleiterschicht aus Silizium ist, die Isolatorschicht aus Siliziumoxid besteht, und der Trägerwafer ebenfalls aus Silizium hergestellt ist. In Fig. 1 ist bereits eine Fluidstruktur 16 eingezeichnet, welche vorzugsweise durch Trockenätzen der Siliziumschicht 14 hergestellt wird. Wie es in der Technik bekannt ist, wird vor dem Trockenätzen ein Photolack auf der Halbleiterschicht aufgebracht, welcher dann an den Stellen, an denen die Fluidstruktur 16 entstehen soll, belichtet wird.

Die vorliegende Erfindung ist genauso auch auf sämtliche Trägerstruktur-Zwischenschicht-Strukturschicht-Systeme anwendbar, bei denen die Zwischenschicht so beschaffen ist, daß sie durch ein Strukturierungsverfahren zum Strukturieren der Strukturschicht im wesentlichen nicht beeinträchtigt wird. Dann ist die Höhe der aktiven Struktur allein durch die Dicke der Strukturschicht festgelegt und wird nicht durch das Strukturierungsverfahren bestimmt, da die Zwischenschicht beim Strukturieren der Strukturschicht nicht beeinträchtigt wird.

Die Halbleiterschicht wird derart strukturiert, daß sich die Fluidstruktur 16 von einer ersten Oberfläche 18a der Siliziumschicht bis zu einer zweiten Oberflächen 18b der Siliziumschicht 14 erstreckt. Die vergrabene Oxidschicht 12 dient für das Trockenätzverfahren als Stoppschicht und sorgt somit für eine hohe Genauigkeit bezüglich der späteren Höhe der fluidischen Strukturen, welche nämlich durch die Dicke der Siliziumschicht d bestimmt wird, die durch den Hersteller des SOI-Wafers in sehr engen Toleranzen spezifiziert ist.

Fig. 2 zeigt eine Schnittansicht durch den Basiswafer, auf dem jedoch nunmehr ein Glaswafer 20 aufgebracht ist, welcher die Fluidstruktur 16 abdeckt. Selbstverständlich kann statt eines Glaswafers 20 jede andere transparente Scheibe auf die Siliziumschicht 14 aufgebracht werden. Zum Anbringen der transparenten Scheibe auf dem Silizium wird jedoch das anodische Bonden bevorzugt, für das sich Glas am besten eignet.

Bei Bedarf kann die Fluidstruktur 16 vor dem Verschließen mit dem Glaswafer 20 mit einer Oxidschicht passiviert werden, welche in Fig. 2 mit dem Bezugszeichen 21 gekennzeichnet ist. Die Oxidschicht 21 kann jedoch weggelassen werden, wenn es für die spätere Anordnung unerheblich ist, ob das Silizium passiviert ist.

Anschließend wird der Trägerwafer 10 von der Rückseite aus durch Schleifen, Ätzen und dergleichen entfernt. Wiederum dient die Oxidschicht 12 als Stoppschicht für einen Ätzprozeß. Anschließend kann die Oxidschicht 12 entfernt werden, so daß die Fluidstruktur 16 gewissermaßen von der Rückseite her wieder geöffnet wird. Ist die Oxidschicht transparent, so kann sie auch verbleiben und wird nicht entfernt.

Erfindungsgemäß erhält man somit ein Fluidbauelement mit einer Strukturschicht 14 mit einer Fluidstruktur 16, wobei die Fluidstruktur eine aktive Höhe d aufweist, die gleich der Dicke der Strukturschicht 14 ist, einer ersten transparenten Scheibe 20 auf einer ersten Oberfläche 18a der Strukturschicht 14, einer transparenten Zwischenschicht 12 auf der anderen Oberfläche der Strukturschicht, und einer zweiten transparenten Scheibe 22 auf der transparenten Zwischenschicht 12, wobei die Strukturschicht und die Zwischenschicht eine Halbleiter-Auf-Isolator- (SOI-) Struktur bilden, wobei die Strukturschicht die Halbleiterschicht ist, und wobei die transparente Zwischenschicht die Isolatorschicht ist.

Zum Entfernen der Zwischenschicht, die als Ätzstopp gewirkt hat, kann ein anderes Ätzverfahren eingesetzt werden, bei dem die Zwischenschicht geätzt wird, während die Strukturschicht als Ätzstopp wirkt.

Im Falle eines Silizium-Siliziumoxid-Systems kann zum Siliziumätzen KOH verwendet werden, das Siliziumoxid nicht angreift. Zum Entfernen der Isolatorschicht kann dagegen Flußsäure verwendet werden, welche Silizium nicht angreift.

Fachleuten sind viele weiteren Material-Systeme bekannt, bei denen zwei Schichten vorhanden sind, bei denen eine durch ein Strukturieren der anderen nicht beeinträchtigt wird.

Diese Situation ist in Fig. 3 dargestellt. Es ist zu sehen, daß durch Entfernen des Trägersubstrats und der Isolatorschicht sowie optional der Passivierungsschicht am Boden der Fluidstruktur die Fluidstruktur an der zweiten Oberfläche 18b freiliegend ist, wobei die aktive Höhe der Fluidstruktur lediglich durch die Dicke der Siliziumschicht der SOI-Struktur bestimmt ist.

In Fig. 4 ist ein fertiges Fluidbauelement gezeigt, bei dem im Vergleich zu Fig. 3 lediglich an der zweiten Oberfläche 18b eine zweite transparente Scheibe 22 angebracht ist, welche im Falle von Silizium als Halbleiterschicht 14 vorzugsweise ebenfalls ein Glaswafer ist, da dieser durch anodisches Bonden günstig mit dem Silizium 14 verbunden werden kann.

Das in Fig. 4 gezeigte Fluidbauelement zeichnet sich somit dadurch aus, daß es oben und unten einen Deckel aus Glas aufweist, und daß die Höhe der Fluidstruktur des Fluidbauelements, die in den Figuren mit d bezeichnet ist, der Dicke der Halbleiterschicht 14 entspricht.

Es sei darauf hingewiesen, daß die Anschlüsse der fluidischen Strukturen nach außen entweder seitlich oder durch Strukturierung von Durchlässen in den Glaswafern 20 und 22 erzeugt werden können.

Eine bevorzugte Anwendung der erfindungsgemäßen Fluidbauelemente besteht darin, dieselben in Verbindung mit einer Analysevorrichtung zu verwenden, die mit Durchlicht arbeitet. Hierzu wird ein Probefluid, das sich innerhalb der Fluidstruktur 16 befindet, unter Verwendung einer Lichtquelle beispielsweise von der oberen Seite aus, also durch den ersten Glaswafer 20 hindurch, beleuchtet. Mittels eines Lichtempfängers wird dann das Transmissionslicht durch das Probenfluid erfaßt, nachdem es durch den zweiten Glaswafer hindurchgetreten ist. Ein Probenfluidanalysator kann dann Eigenschaften des Probenfluids unter Verwendung des Spektrums des eingestrahlten Lichts und unter Verwendung des Spektrums des transmittierten Lichts bestimmen.

Die erfindungsgemäßen Fluidbauelemente können vorteilhaft in der In-Vitro-Diagnostik oder klinischen Diagnostik, der biologischen Grundlagenforschung, insbesondere Genomik, der Forensik, der Lebensmittelanalytik oder dem Screening von medizinischen Produkten eingesetzt werden.

Für die einzelnen Anwendungen können auf der Oberfläche der Fluidstruktur immobilisierte Biomaterialien, wie z. B. DNA-Oligonukleotide, angeordnet sein, die als spezifische interaktionspartner dienen können und damit Funktionselemente definieren. Wenn die Fluidstruktur in Reihen und Spalten ausgestaltet ist, werden die Fluidbauelemente auch als Bio-Chip-Arrays bezeichnet. Es können beliebige Anzahlen (bis zu mehreren Tausend) von biochemischen Funktionselementen angeordnet sein

Die Biomaterialien können unter Verwendung von verschiedenen Verfahren auf der Halbleiter-Fluidstruktur aufgebracht sein, wie z. B. durch Synthese von DNA-Oligos direkt auf der Trägermatrix unter Verwendung von photolithographischen Masken, oder durch Aufspotten von synthetisierten Oligos auf Träger.

Erfindungsgemäß werden flüssige Einsatzstoffe bei der DNA-Arraysynthese durch die Kapillaren des Fluidbauelements in den Chip geführt und binden durch lokale Lichtaktivation an den Kapillarwänden, wie es z. B. in der DE 19940750 A1 beschrieben ist. Damit wird eine schnelle, effiziente und damit kostengünstige Herstellung von Biochips erreicht, so daß sich solche Chips als Massenartikel durchsetzen können. Im Vergleich zu einheitlichen Oberflächen liefern die erfindungsgemäßen Fluidbauelemente günstigere physio-chemische Eigenschaften der Strömungs- und Benetzungsvorgänge in den Fluidstrukturen, insbesondere wenn dieselben solche Dimensionen haben, daß sie als Kapillaren wirken.

## Patentansprüche

1. Fluidbauelement mit folgenden Merkmalen:
einer Strukturschicht (14) mit einer Fluidstruktur (16), wobei die Fluidstruktur eine aktive Höhe (d) aufweist, die gleich der Dicke der Strukturschicht (14) ist;
einer ersten transparenten Scheibe (20) auf einer ersten Oberfläche (18a) der Strukturschicht (14);
einer transparenten Zwischenschicht (12) auf der anderen Oberfläche der Strukturschicht; und
einer zweiten transparenten Scheibe (22) auf der transparenten Zwischenschicht (12),
wobei die Strukturschicht und die Zwischenschicht eine Halbleiter-Auf-Isolator- (SOI-) Struktur bilden, wobei die Strukturschicht die Halbleiterschicht ist, und wobei die transparente Zwischenschicht die Isolatorschicht ist.

2. Analysevorrichtung mit folgenden Merkmalen:
einem Fluidbauelement mit folgenden Merkmalen:
einer Strukturschicht (14) mit einer Fluidstruktur (16), wobei die Fluidstruktur eine aktive Höhe (d) aufweist, die gleich der Dicke der Strukturschicht (14);
einer ersten transparenten Scheibe (20) auf einer ersten Oberfläche (18a) der Strukturschicht (14); und
einer zweiten transparenten Scheibe (22) auf einer transparenten Zwischenschicht (12), die zwischen der zweiten Scheibe und der zweiten Oberfläche der Strukturschicht angeordnet ist,
wobei die Strukturschicht und die Zwischenschicht eine Halbleiter-Auf-Isolator- (SOI-) Struktur bilden, wobei die Strukturschicht die Halbleiterschicht ist, und wobei die transparente zwischenschicht die Isolatorschicht ist;
wobei in dem Fluidbauelement ein Probefluid angeordnet ist;
einer Lichtquelle zum Einstrahlen von Licht auf die erste transparente Scheibe (20) des Fluidbauelements;
einem Lichtempfänger zum Empfangen von Licht, das aus der zweiten transparenten Scheibe (22) des Fluidbauelements austritt; und
einem Probenfluidanalysator zum Bestimmen einer Eigenschaft des Probenfluids unter Verwendung des von der Lichtquelle abgegebenen und von dem Lichtempfänger empfangenen Lichts.

## Claims

1. A fluid device comprising:
a patterned layer (14) with a fluid structure (16), said fluid structure having an active height (d) equal to the thickness of the patterned layer (14);
a first transparent wafer (20) on a first surface (18a) of the patterned layer (14);
a transparent intermediate layer (12) on the other surface of the patterned layer; and
a second transparent wafer (22) on said transparent intermediate layer (12),
wherein the patterned layer and the intermediate layer form a semiconductor on insulator (SOI) structure, wherein the patterned layer is the semiconductor layer, and wherein the transparent intermediate layer is the insulator layer.

2. An analysis apparatus comprising:
a fluid device comprising:
a patterned layer (14) with a fluid structure (16), said fluid structure having an active height (d) equal to the thickness of the patterned layer (14);
a first transparent wafer (20) on a first surface (18a) of the patterned layer (14); and
a second transparent wafer (22) on a transparent intermediate layer (12) arranged between the second wafer and the second surface of the patterned layer,
wherein the patterned layer and the intermediate layer form a semiconductor on insulator (SOI) structure, wherein the patterned layer is the semiconductor layer, and wherein the transparent intermediate layer is the insulator layer;
wherein a sample fluid is arranged in said fluid device;
a light source for transmitting light onto the first transparent wafer (20) of the fluid device;
a light detector for detecting light that emerges from the second transparent wafer (22) of the fluid device; and
a sample fluid analyzer for determining a property of the sample fluid making use of the light emitted by the light source and detected by the light detector.

## Revendications

1. Composant fluidique aux caractéristiques suivantes :
une couche de structure (14) avec une structure à fluide (16), la structure à fluide présentant une hauteur active (d) qui est égale à l'épaisseur de la couche de structure (14) ;
une première plaquette transparente (20) sur une première surface (18a) de la couche de structure (14) ;
une couche intermédiaire transparente (12) sur l'autre surface de la couche de structure ; et
une deuxième plaquette transparente (22) sur la couche intermédiaire transparente (12),
la couche de structure et la couche intermédiaire formant une structure de semi-conducteur sur isolateur (SOI), la couche de structure étant la couche à semi-conducteur et la couche intermédiaire transparente étant la couche d'isolation.

2. Dispositif d'analyse aux caractéristiques suivantes :
un composant fluidique aux caractéristiques suivantes :
une couche de structure (14) avec une structure à fluide (16), la structure à fluide présentant une hauteur active (d) qui est égale à l'épaisseur de la couche de structure (14) ;
une première plaquette transparente (20) sur une première surface (18a) de la couche de structure (14) ; et
une deuxième plaquette transparente (22) sur une couche intermédiaire transparente (12) qui st disposée entre la deuxième plaquette et la deuxième surface de la couche de structure,
la couche de structure et la couche intermédiaire formant une structure de semi-conducteur sur isolateur (SOI), la couche de structure étant la couche à semi-conducteur et la couche intermédiaire transparente étant la couche d'isolation ;
dans le composant fluidique étant disposé un échantillon de fluide ;
une source de lumière destinée à rayonner de la lumière sur la première plaquette transparente (20) du composant fluidique ;
un récepteur de lumière destiné à recevoir de la lumière sortant de la deuxième plaquette transparente (22) du composant fluidique ;
un analyseur d'échantillon de fluide destiné à déterminer une propriété de l'échantillon de fluide à l'aide de la lumière émise par la source de lumière et reçue par le récepteur de lumière.
